Europäisches Patentamt

European Patent Office

Office européen des brevets

(19)

(11) Veröffentlichungsnummer: **0 259 628 B1**

# (12) EUROPÄISCHE PATENTSCHRIFT

(45) Veröffentlichungstag der Patentschrift: **04.03.92**

(51) Int. Cl.⁵: **H03H 9/145**, H03H 9/02

(21) Anmeldenummer: **87111567.1**

(22) Anmeldetag: **10.08.87**

(54) Wandler für eine Filteranordnung mit akustischen Wellen.

(30) Priorität: **29.08.86 DE 3629418**

(43) Veröffentlichungstag der Anmeldung:
**16.03.88 Patentblatt 88/11**

(45) Bekanntmachung des Hinweises auf die
Patenterteilung:
**04.03.92 Patentblatt 92/10**

(84) Benannte Vertragsstaaten:
**DE FR GB IT**

(56) Entgegenhaltungen:
GB-A- 2 168 869
US-A- 4 513 261

IEEE TRANSACTIONS ON CIRCUIT THEORY,
Band CT-20, Nr. 5, September 1973, Seiten
459-470; G.L. MATTHAEI: "Acoustic surfacewave transversal filters"

IEEE TRANSACTIONS ON SONICS AND UL-
TRASONICS, Band SU-22, Nr. 6, November
1975, Seiten 395-401; H. ENGAN: "Surface
acoustic wave multielectrode transducers"

PATENT ABSTRACTS OF JAPAN, Band 7, Nr.
276 (E-215)[1421], 9. Dezember 1983; & JP-
A-58 156 211 (NIPPON DENKI K.K.) 17-09-1983

ELECTRONICS LETTERS, Band 10, Nr. 19, 19.
September 1974, Seiten 395-396; H. ENGAN:
"High-frequency operation of surface-
acoustic-wave multielectrode transducers"

(73) Patentinhaber: **SIEMENS AKTIENGESELL-
SCHAFT**
**Wittelsbacherplatz 2**
**W-8000 München 2(DE)**

(72) Erfinder: **Fleischmann, Bernd, Dipl.-Ing.**
**Von-Frays-Strasse 9**
**W-8000 München 60(DE)**

## Beschreibung

Die vorliegende Erfindung bezieht sich auf einen Wandler nach dem Oberbegriff des Patentanspruches 1 und auf ein Filter mit erfindungsgemäßen Wandlern.

Bekannt sind Anordnungen, die mit akustischen, oberflächennahen Wellen arbeiten. Unter akustischen, oberflächennahen Wellen sind solche Wellen zu verstehen, die weniger präzise als Oberflächenwellen bezeichnet werden, zu denen aber nicht nur die Oberflächenwellen im engeren Sinne (SAW-Wellen; Rayleigh-Wellen), sondern auch Bleustein-Wellen, SSBW-Wellen (surface skimming bulk waves), STW-Wellen (surface transverse waves), Love-Wellen und dgl. gehören. Solche Anordnungen haben Wandler (transducer) zur Umwandlung elektrischer Signale in derartige Wellen bzw. zur Umwandlung derartiger Wellen in elektrische Signale. Solche Wandler sind bekannte Interdigital-Wandler, die interdigital angeordnete Fingerelektroden besitzen, die mit (im Regelfall) jeweils einer Sammelschiene verbunden sind. Der Grundtyp eines solchen Interdigital-Wandlers besteht somit aus zwei, parallel zueinander verlaufenden Sammelschienen (bus bars), von denen wenigstens im wesentlichen rechtwinklig, jeweils auf die andere Sammelschiene gerichtet, schmale, als Fingerelektroden bezeichnete, mit der betreffenden Sammelschiene verbundene Metallisierungsstreifen sich auf der Oberfläche eines Substratkörpers erstrecken. Bei diesem Grundtyp sind aufeinanderfolgend benachbarte Fingerelektroden abwechselnd elektrisch mit den Sammelschienen verbunden. Auch jegliche gedachte Teilfolgen von Fingerelektroden eines Wandlers des Grundtyps sind innerhalb dieses Wandlers gleichphasig wirksam, wie dies auch aus den weiteren Ausführungen hervorgeht.

Die Funktionsweise eines solchen Wandlers ist die, daß durch Anlegen eines elektrischen Signals zwischen diesen beiden Sammelschienen (das Signal liegt dann damit zwischen den benachbarten Fingerelektroden an), zwischen diesen Fingerelektroden in dem piezoelektrischen Material durch piezoelektrischen Effekt die akustische (mechanische) Welle erzeugt wird. Eine solche interdigitale Fingerelektroden-Anordnung besitzt eine Grundresonanz, die der Periodizität der Finger entspricht. Von einem solchen Interdigital-Wandler werden im Regelfall in beiden Richtungen senkrecht zu den Fingerelektroden akustische Wellen im Material ausgesandt. Ein solcher Interdigital-Wandler hat aber auch die nachteilige Eigenschaft, daß innerhalb des Wandlers, nämlich an seinen Fingerelektroden, Reflexionen der erzeugten akustischen Welle auftreten. Zu diesem Zwecke hat man schon vor mehr als einem Jahrzehnt die Verwendung von Split-Fingerelektroden-Anordnungen für Wandler vorgesehen. Der Einsatz solcher Splitfingeranordnungen hat aber den Nachteil, daß die maximal erreichbare Grundresonanzfrequenz nur halb so hoch ist wie bei einem Wandler nach dem Grundtyp, nämlich unter der Voraussetzung gleich breiter Fingerelektroden. Die maximal mögliche Grundfrequenz für solche Wandler ist nämlich durch die technologische Grenze für die Herstellung von Elektrodenfingern mit geringst möglicher Breite bestimmt. Diese Abmessung liegt derzeit bei etwa 1 $\mu$m bei etwa 1 $\mu$m Abstand (lichter Weite zwischen benachbarten Fingerelektroden).

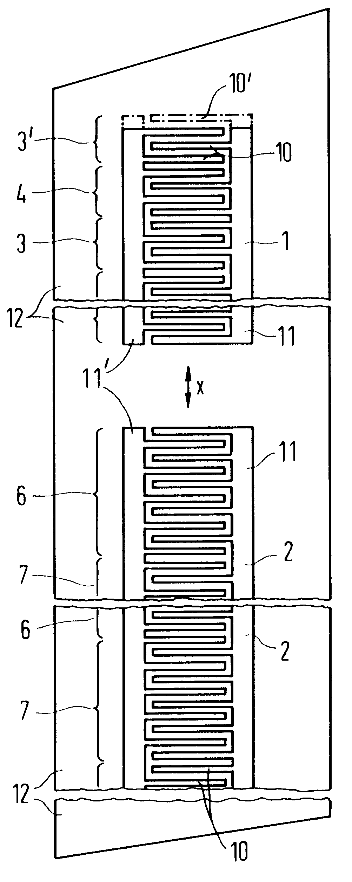

Aus den Druckschriften IEEE Transactions on Circuit Theorie, Vol. CT-20 (1973) S. 459-470 und IEEE Transactions Sonics and Ultrasonics, Bd. SU-22 (1975), S. 395-401 sind z.B. aus Figur 3 Wandleranordnungen verschiedener Ausführung bekannt. In Figur 3 zeigt die oberste Zeile eine Wandleranordnung des Grundtyps. Die dritte Zeile zeigt eine ebenfalls schon beschriebene Splitfingeranordnung. Der Wandler der zweiten Zeile zeigt eine Anordnung, die dem Prinzip nach zwischen diesen beiden vorangehend beschriebenen Wandleranordnungen liegt. Die vierte Zeile zeigt schließlich eine Splitfingeranordnung mit zusätzlich eingefügten Blindfingern, nämlich Finger die an keine der Sammelschienen angeschlossen sind, d.h. floatendes-Potential haben. Rechts von diesen Wandleranordnungen ist in dieser Figur 3 die Lage der Resonanzfrequenzen des jeweiligen Wandlers angegeben. Zur Zeile 1 ist die allein auftretende Grundresonanzfrequenz des zugehörigen Wandlers angegeben. In den darunterliegenden Zeilen sind jeweils die (immer kleiner werdenden) Grundfrequenzen und die zugehörigen (höheren) Harmonischen bzw. Oberwellenfrequenzen angegeben. Der Splitfingerwandler nach Zeile 3 hat die (wie schon oben erwähnt) zum Wandler der Zeile 1 nur halb so hohe Grundfrequenz und eine Resonanz bei der dritten Oberwelle. Entsprechendes gilt für die übrigen Zeilen. Zu dieser Figur 3 ist aber darauf hinzuweisen, daß ein Betrieb des jeweiligen Wandlers bei seiner Oberwelle wesentlich weniger zweckmäßig ist. Es ist somit festzuhalten, daß die Weiterentwicklung eines Wandlers der Zeile 1 in Richtung der Wandler der nachfolgenden Zeilen 2, 3 und 4 der Figur 3 in dieser Druckschrift zu zunehmender Verringerung desjenigen Frequenzwertes führt, der als Grundfrequenz nutzbar ist.

Ein anderer Weg zur Beseitigung der inneren Reflexionen in einem Interdigital-Wandler des Grundtyps ist der, innerhalb der Fingerelektroden-Anordnung des Wandlers ungleiche (lichte) Abstände vorzusehen. Angenommen die Fingerbreite eines solchen Wandlers ist Lambda/4 (Lambda = Wellenlänge der akustischen Welle bei Grundresonanz) und damit der schmale Abstand zwischen benachbarten Fingern ebenfalls gleich Lambda/4 gewählt, so beträgt bei diesem Wandler der breitere lichte Abstand zwischen Elektrodenfingern Lambda/2, wodurch destruktive Interferenzen für reflektierte Anteile der akustischen Welle bewirkt werden. Ein solcher Wandler hat bei vergleichbarer Fingerbreite die gleiche Grundfrequenz wie ein Wandler des Grundtyps. Ein solcher Wandler hat aber relativ starke Nebenmaxima, die zu Störungen führen können. Ein weiterer Nachteil dieses Wandlers ist der ungleiche Abstand zwischen den Elektrodenfingern. Ungleiche Zwischenräume führen nämlich bei dem bei der Herstellung der Struktur notwendigerweise anzuwendenden Belichtungsverfahren zu Ungleichmäßigkeiten in der hergestellten Struktur, was weitere zusätzliche Störungen im elektrischen Verhalten eines solchen Wandlers bewirkt.

Eine rein zufällige, aber auch nur scheinbare Übereinstimmung mit der Erfindung haben als Code-Generatoren ausgebildete und betriebene Wandler, wie sie aus den beiden Druckschriften IEEE Transactions on Circuit Theory, Bd. CT-20, No. 5, Sept. 1973, S. 459 bis 470, insbesondere Figur 13 und Matthews, Surface Wafe Filters, (1977), S. 307 bis 346, Verlag John Wiley & Sons, dort insbesondere Figur 7.1, bekannt sind. Es handelt sich dort um Code-Generatoren, die Fingergruppen besitzen, die aufgrund ihrer unterschiedlichen Gruppenlänge bzw. Fingeranzahl der einzelnen Gruppen einen inkorpurierten Code besitzen. Zum Beispiel hat gemäß Figur 13 die von links her erste Fingergruppe fünfmal so große Länge wie die schmalste Fingergruppe. Gleiche Fingeranzahl für alle Gruppen ist bei einem solchen Code-Generator unmöglich bzw. hätte dieser dann (sinnloserweise) keinen Informationsinhalt.

Aufgabe der vorliegenden Erfindung ist es, eine Lösung des Problems der Unterdrückung der inneren Wellen-Reflexionen eines Interdigital-Wandlers zu finden, mit der jedoch keine verringerte nutzbare (Grund-)frequenz des Wandlers in Kauf zu nehmen ist und bei deren Anwendung (vergleichsweise zu bekannten Wandlern) keine zusätzlichen technologischen Herstellungs-Schwierigkeiten auftreten.

Diese Aufgabe wird mit einem Wandler mit den Merkmalen des Patentanspruches 1 gelöst und weitere Ausgestaltungen gehen aus den Unteransprüchen hervor. Eine besonders vorteilhafte Weiterbildung der Erfindung ist ein Filter mit wenigstens zwei erfindungsgemäßen Wandlern, von denen ein Wandler eine Anzahl Fingerelektroden je Gruppe hat, die verschieden ist von der Anzahl Fingerelektroden der Gruppen eines anderen Wandlers bei insbesondere etwas unterschiedlicher Fingerperiodizität (des jeweiligen Wandlers).

Bei den im Anspruch angegebenen "Fingerelektroden" handelt es sich um solche, die aufgrund ihrer elektrischen Verbindung mit einer der Sammelschienen anregungsaktiv sind. Es können bei einem Wandler nämlich auch sogenannte Blindfinger (dummy fingers) vorgesehen sein, die zwar nicht funktionslos sind, aber an der elektromechanischen Energieumwandlung fast keinen Anteil haben .

Der vorliegenden Erfindung liegt die Überlegung zugrunde, daß ein erfindungsgemäßer (von einem Wandler des Grundtyps abweichender bzw. abweichend betriebener) Wandler ebenso wie bei einem Wandler des Grundtyps durchwegs gleich große lichte Abstände zwischen den Fingerelektroden haben soll. Mit dem erfindungsgemäßen Wandler kann aber nicht nur diese vorteilhafte Bedingung eingehalten werden, sondern außerdem ergibt sich wenigstens für viele Konzeptionen noch der Vorteil, daß eine zum Betrieb des Wandlers nutzbare Resonanzfrequenz (für die Grundwellen-Anregung) verfügbar ist, die sogar noch höher ist als bei einem Wandler nach dem Grundtyp, und zwar bei verglichen mit einem Wandler des Grundtyps gleich großer (minimaler) Breite der Fingerelektroden und Breite der lichten Abstände. Die bei einem gindungsgemäßen Wandler auftretenden zwei benachbarten Frequenzen sind keine Harmonischen bzw. Oberwellen, sondern sie sind zwei voneinander etwas verschiedene sozusagen als Paar auftretende Grundfrequenzen. Beide Grundfrequenzen sind praktisch gleichwertig und liegen symmetrisch zur Grundfrequenz eines die gleichen Fingerabmessungen und -abstände aufweisenden Wandlers des Grundtyps. Es steht bei der Erfindung somit jeweils eine Grundfrequenz mit einem vergleichsweise zu einem Wandler des Grundtyps höherem Frequenzwert zur Verfügung. Mit der Erfindung ist also erreicht, daß bei gleich großem technologischen Aufwand und nur ebenso minimalzu haltenden, auf der Herstellung beruhenden Störungen mit (gegenüber dem Grundtyps unverändert) gleich großer Fingerbreite die "Grenzfrequenz" für die Anwendung solcher Filter erhöht ist. Es wird mit der Erfindung also nicht nur Verringerung der inneren Reflexionen erreicht, sondern es ist sogar außerdem noch der Frequenzbereich der Anwendung solcher Wandler erweitert.

Die schon oben angesprochene Weiterbildung der Erfindung besteht darin, ein Filter mit zwei Wandlern bzw. ein Filter mit wenigstens zwei Wandlern so auszugestalten, daß die zwei Wandler bzw. wenigstens zwei dieser mehreren Wandler für die Gruppen des jeweiligen Wandlers verschieden große Anzahl Finger-elektroden haben. Z. B. hat der eine Wandler des Filters Fingergruppen mit jeweils vier Fingerelektroden und der andere Wandler bzw. ein anderer Wandler dieses Filters zehn Fingerelektroden je Gruppe. Dies führt dazu, daß die jeweils symmetrisch angeordneten Grundfrequenzen des einen Wandlers des erfindungsgemäßen Typs verschieden großen Abstand voneinander haben, verglichen mit dem anderen Wandler (mit abweichender Fingerelektroden-Anzahl seiner Gruppen). Indem man den einen Wandler hinsichtlich seiner Fingerperiodizität so bemißt, daß seine obere Grundfrequenz gleich groß wie die obere Grundfrequenz des anderen Wandlers ist, erreicht man, daß die dazu unteren Grundfrequenzen der beiden Wandler bei voneinander verschiedenen Frequenzwerten liegen.

Zwei Alternativen dazu sind, die jeweils unteren Grundfrequenzen gleich groß zu machen oder die obere Grundfrequenz des einen Wandlers gleich groß wie die untere Grundfrequenz des anderen Wandlers zu bemessen. Diese Alternativen haben jeweilige Vorteile hinsichtlich der Unterdrückung der anderen Grundfrequenz (-en).

Die beigefügte Figur dient weiteren Erläuterungen zur Erfindung.

Die Figur zeigt ein Filter mit zwei erfindungsgemäßen Wandlern, und zwar in der Ausgestaltung mit voneinander verschiedener Fingerelektrodenanzahl der beiden Wandler. In der Figur bedeuten:

| | |
|---|---|
| 1, 2 | je einen Wandler in erfindungsgemäßer Ausführungsform mit Gruppen mit jeweils vier bzw. jeweils zehn Fingerelektroden |
| 3, 4, | Gruppen des Wandlers 1 mit jeweils alternierend angeschlossenen Elektrodenfingern |
| 3' | eine Gruppe, der am (einen) ende des Wandlers (1) ein (noch gestrichelt dargestellter) Elektrodenfinger 10' fehlt. Dieser Finger 10' kann alternativ als Blindfinger vorhanden sein. |
| 6, 7 | Gruppen des Wandlers 2 mit jeweils alternierend angeschlossenen Elektrodenfingern |
| 10 | Fingerelektroden, die mit einer Sammelschiene verbunden sind. |
| 11, 11' | Sammelschienen |
| 12 | Substrat |
| x | Wellenfortpflanzungsrichtung |

Der Wandler 1 hat Fingergruppen 3, 4 mit je vier Fingerelektroden, von denen zwei Fingerelektroden mit der Sammelschiene 11 und zwei Fingerelektroden mit der Sammelschiene 11' verbunden sind. Diese Fingerelektroden 10 greifen interdigital ineinander. Entsprechendes gilt für die Gruppen 6 und 7 mit je zehn Elektrodenfingern für den Wandler 2.

Eine besondere Ausgestaltung ist mit der Gruppe 3' dargestellt. An einem Ende bzw. an den beiden Enden eines Wandlers, hier des Wandlers 1 kann die (jeweils) letzte Fingergruppe als Fingergruppe 3' verkürzt sein, d.h. weniger Fingerelektroden aufweisen als für die übrigen Gruppen 3, 4 des Wandlers 1 vorgesehen ist. Bei einer Fingergruppe 3' ist eine (letzte, nur noch gestrichelt dargestellte) Fingerelektrode 10' weggelassen. Anstelle z.B. eine solche Fingerelektrode 10' weg zu lassen kann auch ein Blindfinger vorgesehen sein.

An einem Ende bzw. an beiden Enden der Wandler können gemäß einer weiteren Ausführungsvariante auch Blindfinger (dummy fingers) hinzugefügt sein. Blindfinger sind Finger, die entweder an derjenigen Sammelschiene angeschlossen sind, mit der der äußerste (erste bzw. letzte) anregungsaktive Elektrodenfinger verbunden ist oder die an keiner Sammelschiene angeschlossen sind. Sie dienen meist der elektrischen Abschirmung benachbarter Wandler voneinander, befinden sich dann also an einander zugewandten Enden zweier Wandler. Da solche Blindfinger nicht anregungsaktiv sind, sind sie bei der erfindungsgemäß jeweils vorgesehenen Anzahl von Elektrodenfingern (weil sie tatsächlich keine Elektrodenfinger sind) nicht berücksichtigt.

Aus der Figur ist zu ersehen, daß an den einander gegenüberliegenden Enden zweier Gruppen 3 und 4 bzw. 6 und 7 aufeinanderfolgende Fingerelektroden nicht alternativ, sondern mit ein und derselben Sammelschiene 11 bzw. 11' verbunden sind. Für den Fall, daß ein solcher Wandlers 1, 2 ein solcher des Grundtyps sei bzw. bei der Frequenz des Grundtyps betrieben werden sollte, würden die beiden benachbarten Gruppen 3, 4 bzw. 6, 7 zueinander gegenphasig sein. Die von einer Gruppe 3 bei der Frequenz des Grundtyps erzeugte Erregung würde phasenentgegengesetzt derjenigen elektrischen Erregung sein, die von eben dieser benachbarten Gruppe 4 erzeugt werden würde. Bei Betrieb des Wandlers 1 bzw. des Wandlers 2 in der für den jeweiligen Wandler vorgesehenen Frequenzlage arbeiten natürlich sämtliche Gruppen 3, 3', 4 bzw. 6 und 7 phasengleich zusammen, jedoch ohne die durch das Vorhandensein der Fingerelektroden mit der Erfindung zu behebenden interdigitalen Reflexionen, die von einem Wandler des Grundtyps her bekannt sind.

Mit x ist die Wellenfortpflanzungsrichtung der beiden Wandler 1 und 2 auf dem Substrat 12 angegeben. Zum Beispiel kann der Wandler 1 als Wandler für die Erzeugung einer akustischen Welle in der Oberflächen des Substrats 12 (mit entsprechender elektrischer Anregung der Fingerelektroden) betrieben werden und der Wandler 2 dient als Empfangswandler, in dem das in der erzeugten akustischen Oberflächenwelle enthaltene Signal in ein elektrisches Signal zurückumgewandelt wird.

Die Periodizität der Fingerelektroden 10 eines jeweiligen Wandlers 1 bzw. 2 bestimmt die bei erfindungsgemäßen Wandlern paarweise auftretenden Grundfrequenzen (bei einem Wandler des Grundtyps die nur eine Grundfrequenz). Zweckmäßige Ausführungsformen eines Filters mit erfindungsgemäßen Wandlern ergeben sich, wenn man für beide Wandler voneinander verschiedene Fingeranzahl je Gruppe angibt, d.h. der eine Wandler 1 Fingergruppen mit je vier Fingerelektroden hat und der Wandler 2 Fingergruppen mit je zehn Fingerelektroden besitzt. Die Höhe der paarweisen Grundfrequenzen ist nämlich eine Funktion der Anzahl der Fingerelektroden je Gruppe. Größere (z.B. zehn Finger) Fingerelektrodenanzahl je Gruppe führt zu etwas höherer unterer Grundfrequenz und niedrigerer oberer Grundfrequenz vergleichsweise zu einem Wandler mit geringerer Fingerelektrodenanzahl je Gruppe (z.B. nur vier Fingerelektroden wie beim Wandler 1).

Durch entsprechende Abstimmung der Periodizität der Fingerelektrodenanordnung (Abstände und Fingerbreiten) läßt sich vorteilhafterweise erreichen, daß die obere Grundfrequenz des einen Wandlers und die untere Grundfrequenz des anderen Wandlers auf ein und demselben Frequenzwert liegen oder daß man für beide Wandler die jeweils obere Grundfrequenz (oder ggf. auch die jeweils untere Grundfrequenz) als übereinstimmende Betriebsfrequenz auswählt und vorgibt.

## Patentansprüche

1. Wandler (1, 2) für eine Anordnung, die mit akustischen, oberflächennahen Wellen arbeitet, mit interdigital angeordneten Fingerelektroden (10) und mit zwei Sammelschienen (11, 11') mit elektrischen Anschlüssen auf piezoelektrischem Material,
wobei solche Fingerelektroden im wesentlichen gleich breit sind und gleiche Abstände voneinander haben und mit den Sammelschienen verbunden sind,
**gekennzeichnet** dadurch
- daß die Fingerelektroden (10) des Wandlers (1; 2) als Gruppen (3, 4; 6, 7) mit einer vorgegeben gleich großen Anzahl von mindestens vier aufeinanderfolgenden Fingerelektroden, die untereinander innerhalb jeder Gruppe alternierend mit der einen bzw. der anderen der beiden Sammelschienen verbunden sind, vorliegen und
- daß an den einander gegenüberliegenden Enden zweier Gruppen (3, 4; 6, 7) aufeinanderfolgende Fingerelektroden mit ein und derselben Sammelschiene (11, 11') verbunden sind, so daß jeweils aufeinanderfolgende Gruppen (3-4, 4-3; 6-7, 7-6 ...) in dem Wandler (1, 2) derart zueinander angeordnet sind, daß diese benachbarten Gruppen zueinander gegenphasig wirksam sind.

2. Wandler nach Anspruch 1,
**gekennzeichnet** dadurch,
daß wenigstens eine (3') der beiden an den beiden Enden des Wandlers befindlichen Gruppen eine gegenüber der vorgegebenen Fingerelektroden-Anzahl geringere Anzahl an mit einer jeweiligen Sammelschiene verbundenen Fingerelektroden (10) hat und daß die übrigen in der Mitte befindlichen Gruppen die vorgegebene Anzahl von Fingerelektroden aufweisen und diese Gruppen die Mehrzahl der Gruppen des Wandlers bilden.

3. Wandler nach Anspruch 1 oder 2,
**gekennzeichnet** dadurch,
daß die Anzahl der Fingerelektroden je Gruppe nicht größer als etwa 20 ist.

4. Wandler nach Anspruch 1, 2 oder 3,
**gekennzeichnet** dadurch,
daß die Mindestanzahl der Fingerelektroden einer jeweiligen Gruppe gleich 10 ist.

5. Filter mit wenigstens zwei Wandlern nach Anspruch 1, 2, 3 oder 4,
**gekennzeichnet** dadurch,
daß wenigstens zwei dieser Wandler verschieden große Anzahl Fingerelektroden einer Gruppe haben.

6. Filter mit wenigstens zwei Wandlern nach einem der Ansprüche 1 bis 4,
**gekennzeichnet** dadurch,
daß diese Wandler so bemessen sind, daß die obere Grundfrequenz des einen Wandlers gleich der unteren Grundfrequenz des anderen Wandlers ist.

7. Filter mit wenigstens zwei Wandlern nach einem der Ansprüche 1 bis 4,
**gekennzeichnet** dadurch,
daß die unteren oder daß die oberen Grundfrequenzen dieser Wandler übereinstimmen.

## Claims

1. Transducer (1, 2) for an arrangement operating with acoustic waves close to the surface, comprising interdigitally arranged finger electrodes (10) and two buses (11, 11') having electrical terminals on piezo electric material, such finger electrodes having essentially identical width and identical distances from one another and being connected to the buses, characterised by the fact
- that the finger electrodes (10) of the transducer (1, 2) are present as groups (3, 4; 6, 7) having a predetermined identically large number of at least four successive finger electrodes, which are connected to one and the other of the two buses alternating between one another within each group, and

- that at the mutually opposite ends of two groups (3, 4; 6, 7), successive finger electrodes are connected to one and the same bus (11, 11') so that in each case successive groups (3-4, 4-3; 6-7, 7-6 ...) in the transducer (1, 2) are arranged with respect to one another in such a manner that these adjacent groups are effective in opposite phase with respect to one another.

2. Transducer according to Claim 1, characterised by the fact that at least one (3') of the two groups located at the two ends of the transducer has a lower number of finger electrodes (10) connected to one respective bus compared with the predetermined number of finger electrodes and that the remaining groups located in the centre have the predetermined number of finger electrodes and these groups form the majority of the groups of the transducer.

3. Transducer according to Claim 1 or 2, characterised by the fact that the number of finger electrodes of each group is no greater than about 20.

4. Transducer according to Claim 1, 2 or 3, characterised by the fact that the minimum number of finger electrodes of a respective group is equal to 10.

5. Filter having at least two transducers according to Claim 1, 2, 3 or 4, characterised by the fact that at least two of these transducers have a different number of finger electrodes of one group.

6. Filter having at least two transducer according to one of Claims 1 to 4, characterised by the fact that these transducers are dimensioned in such a manner that the upper fundamental frequency of one transducer is equal to the lower fundamental frequency of the other transducer.

7. Filter having at least two transducers according to one of Claims 1 to 4, characterised by the fact that the lower or that the upper fundamental frequencies of these transducers correspond to one another.

**Revendications**

1. Transducteur (1,2) pour un dispositif qui opère avec des ondes acoustiques proches de la surface, comportant des électrodes en forme de doigts (10) interdigitées et deux barres collectrices (11,11') comportant des bornes électriques réalisées en un matériau piézoélectrique,
   et dans lequel de telles électrodes en forme de doigts possèdent des largeurs sensiblement identiques, sont séparées réciproquement par des distances identiques et sont reliées aux barres collectrices,
   caractérisé par le fait
   - que les électrodes en forme de doigts (10) du transducteur (1;2) sont présentes sous la forme de groupes (3,4;6,7) possédant un même nombre prédéterminé d'au moins quatre électrodes en forme de doigts successives, qui sont raccordées, d'une manière alternée à l'intérieur de chaque groupe, à l'une et à l'autre des deux barres collectrices, et
   - qu'aux extrémités réciproquement opposées de deux groupes (3,4;6,7), des électrodes en forme de doigts successives sont raccordées à une même barre collectrice (11,11') de sorte que des groupes respectivement successifs (3-4, 4-3; 6-7, 7-6...) dans le transducteur (1,2) sont disposés les uns par rapport aux autres de telle sorte que ces groupes voisins sont actifs en opposition de phase.

2. Transducteur suivant la revendication 1, caractérisé par le fait qu'au moins l'un (3') des deux groupes situés aux deux extrémités du transducteur possède un nombre d'électrodes en forme de doigts (10) raccordées à une barre collectrice respective, ce nombre étant inférieur au nombre prédéterminé d'électrodes en forme de doigts, et que les autres groupes, situés au centre, possèdent le nombre prédéterminé d'électrodes en forme de doigts et que ces groupes forment la multiplicité des groupes transducteurs.

3. Transducteur suivant la revendication 1 ou 2, caractérisé par le fait que le nombre des électrodes en forme de doigts dans chaque groupe n'est pas supérieur à environ 20.

4. Transducteur suivant la revendication 1, 2 ou 3, caractérisé par le fait que le nombre minimum des électrodes en forme de doigts d'un groupe respectif est égal à 10.

5. Filtre comportant au moins deux transducteurs suivant la revendication 1, 2, 3 ou 4, caractérisé par le fait que dans au moins deux de ces transducteurs, un groupe possède des nombres différents d'électrodes en forme de doigts.

6. Filtre comportant au moins deux transducteurs suivant l'une des revendications 1 à 4, caractérisé par le fait que ces transducteurs sont dimensionnés de manière que la fréquence limite supérieure d'un transducteur est égale à la fréquence limite inférieure de l'autre transducteur.

7. Filtre comportant au moins deux transducteurs suivant l'une des revendications 1 à 4, caractérisé par le fait que les fréquences limites inférieures ou les fréquences limites supérieures de ces transducteurs sont identiques.